# EUROPEAN PATENT APPLICATION

(11) **EP 4 654 763 A1**
(43) Date of publication of application: **26.11.2025**
(21) Application number: 24835069.6
(22) Date of filing: 12.03.2024
(51) Int. Cl.: H05K 5/02

(54) **STRUCTURAL PART, PREPARATION METHOD FOR STRUCTURAL PART AND ELECTRONIC DEVICE**

(30) Priority: 03.07.2023 CN 202310808191
(71) Applicant: Honor Device Co., Ltd., Shenzhen, Guangdong 518040 (CN)
(72) Inventor: ZHANG, Hongming, Shenzhen, Guangdong 518040 (CN); WANG, Xiaoguang, Shenzhen, Guangdong 518040 (CN); HUO, Guoliang, Shenzhen, Guangdong 518040 (CN); ZHOU, Qichen, Shenzhen, Guangdong 518040 (CN); FENG, Yu, Shenzhen, Guangdong 518040 (CN); ZANG, Yongqiang, Shenzhen, Guangdong 518040 (CN)
(74) Representative: Thun, Clemens
(86) International application number: PCT/CN2024/081143
(87) International publication number: WO 2025/007582

(57) **Abstract**

This application provides a structural member, a method for manufacturing a structural member, and an electronic device. The structural member includes a substrate and a metal coating layer. The substrate includes an outer surface. The metal coating layer is provided on the outer surface. The substrate is made of a polymer material having a polar group. A heat distortion temperature of the polymer material is greater than or equal to 175°C. A coefficient of thermal expansion of the polymer material is less than or equal to 60* 10⁻⁶/K. In the structural member shown in this application, the substrate is made of the polymer material having a polar group. The polar group of the polymer material helps form a strong bonding force with the metal coating layer. The metal coating layer may be directly formed on the outer surface of the substrate without the need to design a priming coat between the metal coating layer and the outer surface. This simplifies a manufacturing process of the structural member, and improves production efficiency of the structural member.

## Description

This application claims priority to Chinese Patent Application No. 202310808191.3, filed with the China National Intellectual Property Administration on July 3, 2023 and entitled "STRUCTURAL MEMBER, METHOD FOR MANUFACTURING STRUCTURAL MEMBER, AND ELECTRONIC DEVICE", which is incorporated herein by reference in its entirety.

### TECHNICAL FIELD

This application relates to the technical field of electronic devices, and in particular, to a structural member, a method for manufacturing a structural member, and an electronic device.

### BACKGROUND

With the continuous development of science and technology, mobile phones and other electronic devices are widely used in people's daily life and work, and have become indispensable daily necessities for people. In current electronic devices, structural members are often primed on a substrate surface and then coated to achieve a metal-like effect, to improve the aesthetic appearance of the structural member. This results in a complex manufacturing process of the structural member, and reduces production efficiency of the structural member.

### SUMMARY

This application provides a structural member, a method for manufacturing a structural member, and an electronic device, to simplify a manufacturing process of the structural member and improve production efficiency of the structural member.

According to a first aspect, this application provides a structural member, including a substrate and a metal coating layer. The substrate includes an outer surface. The metal coating layer is arranged on the outer surface. The substrate is made of a polymer material having a polar group. A heat distortion temperature of the polymer material is greater than or equal to 175°C. A coefficient of thermal expansion of the polymer material is less than or equal to 60* 10⁻⁶/K.

In the structural member shown in this application, the substrate is made of the polymer material having a polar group. The heat distortion temperature of the polymer material is high, and the coefficient of thermal expansion of the polymer material is relatively low. The polar group of the polymer material may form a strong bonding force with metal atoms in the metal coating layer, and a bonding force between the substrate and the metal coating layer is relatively strong. Therefore, the metal coating layer may be directly formed on the outer surface of the substrate without the need to design a priming coat between the metal coating layer and the outer surface. This simplifies a manufacturing process of the structural member, and improves production efficiency of the structural member. Moreover, since the priming coat does not need to be formed by spraying, no large amount of solvent is required during the manufacturing of the structural member. This reduces pollution caused during the manufacturing of the structural member.

In addition, during formation of the metal coating layer, since the polymer material has good heat resistance, thermal deformation does not occur in the substrate. This not only facilitates the formation of the metal coating layer, enhances the bonding force between the substrate and the metal coating layer, and can ensure quality of the metal coating layer, but also can effectively improve productivity of the structural member. Moreover, during the formation of the metal coating layer, a temperature of an environment where the metal coating layer is formed where the substrate is located experiences a process from a low temperature (such as a room temperature) to a high temperature (such as a temperature at which metal coating may be performed) and then to a low temperature (such as a temperature after cooling). Due to the relatively low coefficient of thermal expansion of the polymer material, the substrate does not expand or contract significantly. This helps improve the quality of the metal coating layer and ensures use reliability of the structural member.

Moreover, since the coefficient of thermal expansion of the metal coating layer is between 5*10⁻⁶/K and 25*10⁻⁶/K, the relatively low coefficient of thermal expansion of the polymer material may reduce a difference in the coefficients of thermal expansion between the substrate and the metal coating layer. When the structural member is used in a high-temperature or low-temperature environment, a deformation difference between the substrate and the metal coating layer is not too great. This not only helps enhance structural stability between the substrate and the metal coating layer, but also may prevent the metal coating layer from cracking.

A test for the heat distortion temperature of the polymer material meets the international standard ISO 75-1/-2, and a test for the coefficient of thermal expansion of the polymer material meets the international standard ISO 11359.

In an implementation, a flow rate of the polymer material weighing 2.16 kg at 350°C is greater than or equal to 22 g/10 min. A test for fluidity of the polymer material meets the international standard ISO 1133. In other words, the polymer material has high fluidity. In other words, the polymer material used for the substrate has a high melt index and high fluidity. During formation of the substrate through injection molding, this not only helps obtain a high-quality outer surface, but also helps achieve high-precision molding of the substrate, and may reduce other appearance defects such as weld marks on the substrate.

In an implementation, a mirror effect grade of the outer surface of the substrate is less than or equal to A3, and roughness of the outer surface of the substrate is less than or equal to 0.06 µm. In other words, high quality of the outer surface of the substrate helps improve the bonding force between the substrate and the metal coating layer.

In an implementation, surface hardness of the outer surface of the substrate is greater than or equal to F, that is, the outer surface of the substrate has relatively high surface hardness. This not only helps reduce scratches on the substrate, but also may prevent the metal coating layer from cracking.

In an implementation, notched impact strength of the substrate is greater than or equal to 4 kJ/m². A test for the notched impact strength of the substrate meets the international standard ISO 180. The substrate has relatively high impact strength. This helps improve toughness and impact strength of the structural member, and enhances the use reliability of the structural member.

In an implementation, a flexural modulus of the substrate is greater than or equal to 2500 MPa. A test for the flexural modulus of the substrate meets the international standard ISO 178. The substrate has a high modulus. This not only helps improve strength and rigidity of the structural member, but also may directly form the metal coating layer on the outer surface of the substrate without the need to design a priming coat.

In an implementation, the outer surface is provided with a textured pattern. The textured pattern includes a plurality of textured pattern units, and the metal coating layer covers the textured pattern. For example, a cross section of each textured pattern unit is in a shape of a triangle. Since the metal coating layer may be directly formed on the outer surface, no priming coat is accumulated in a sharp corner position between two adjacent textured pattern units. The sharp corner position of each textured pattern unit is not to become blunt. This helps enhance metal texture of the structural member.

In an implementation, the polar group is an imide group, a sulfone group, a diphenyl sulfone group, or a phthalamide group. The polar group has high temperature resistance.

In an implementation, the polymer material includes at least one of polyetherimide, polysulfone plastics, polyethersulfone, polyphenylene sulfone resin, and polyphthalamide. The polymer material meets the international standard ISO 75-1/-2.

In an implementation, the substrate does not contain a weld line.

In an implementation, a material of the metal coating layer includes at least one of titanium, chromium, tungsten, vanadium, niobium, zirconium, hafnium, titanium carbide, and tungsten carbide.

In an implementation, a thickness of the metal coating layer is between 0.2 µm and 8 µm.

In an implementation, a pencil hardness test of the metal coating layer is ≥ 2H, and adhesion of the metal coating layer is ≥ 4B. The metal coating layer not only has a high-quality metal effect, but also may obtain different colors by selecting different metal materials. This helps realize personalized design of the structural member. The adhesion of the metal coating layer is measured through a cross-cut test.

According to a second aspect, this application provides an electronic device, including a housing and any one of the foregoing structural members, where the structural member is mounted to the housing.

In the electronic device shown in this application, the substrate of the structural member is made of the polymer material having a polar group. The polar group of the polymer material helps form a strong bonding force with the metal coating layer. The metal coating layer may be directly formed on the outer surface of the substrate without the need to design a priming coat between the metal coating layer and the outer surface. This simplifies a manufacturing process of the structural member, and improves production efficiency of the structural member. Moreover, since the priming coat does not need to be formed by spraying, no large amount of solvent is required during the manufacturing of the structural member. This reduces pollution caused during the manufacturing of the structural member.

In an implementation, the structural member is a button, a card holder, or a decoration member.

In an implementation, the housing adopts the same structure as the structural member.

According to a third aspect, this application provides a method for manufacturing a structural member, including:
forming a substrate through injection molding of a polymer material having a polar group, where a heat distortion temperature of the polymer material is greater than or equal to 175°C, a coefficient of thermal expansion of the polymer material is less than or equal to 60*10⁻⁶/K, and the substrate includes an outer surface; and
forming a metal coating on the outer surface.

In the method for manufacturing a structural member shown in this application, the metal coating layer is directly formed on the outer surface of the substrate. Through the method, the structural member with a high-precision metal-like appearance effect may be easily manufactured. The structural member has high gloss, good flatness, excellent reliability, strong product performance, low costs, and a light weight. The metal coating layer and the substrate are firmly bonded, have excellent wear resistance, and are not easy to crack or fall off. The structural member manufactured through the method has both an exquisite appearance effect and a light weight, and has strong product liquidity. Moreover, the structural member manufactured through the method has relatively high strength, good toughness, good dimensional stability, and excellent chemical resistance.

In an implementation, in the step of forming the metal coating on the outer surface, the metal coating is formed through a process of physical vapor deposition. For example, the metal coating layer is formed through a high-temperature sputtering coating process. The metal coating layer has high purity, good density, and a strong bonding force with the substrate. This helps improve the use reliability of the structural member. In addition, compared with the conventional vacuum non-conductive coating process of forming the metal coating layer, the high-temperature sputtering coating process is simpler and pollution-free. Furthermore, the non-conductive vacuum coating process is often used for surface decoration of glass-fiber-filled polycarbonate resin components. Through use of the physical vapor deposition process, three spraying steps may be omitted. In particular, components using the non-conductive vacuum coating are also prone to resin accumulation and fat edges. This is not conducive to achieving high-quality metallization effects.

In an implementation, in the step of forming the substrate through injection molding of the polymer material having the polar group, a mold temperature of an injection mold is between 135°C and 170°C, a temperature of the polymer material is between 330°C and 400°C, an injection pressure of the polymer material injected into the injection mold is between 700 bar and 1500 bar, and an injection speed is greater than or equal to 20 mm/s, so as to improve surface quality of the substrate.

In an implementation, the polymer material is injected into the injection mold through single-point gate feeding. This helps reduce an appearance defect such as the weld line on the outer surface of the substrate and improve the surface quality of the substrate.

### BRIEF DESCRIPTION OF DRAWINGS

To describe the technical solutions of embodiments of this application more clearly, the accompanying drawings required for use in embodiments of this application are described below.
FIG. 1 is a schematic structural diagram of an electronic device according to an embodiment of this application;
FIG. 2 is a schematic diagram of a back structure of the electronic device shown in FIG. 1;
FIG. 3 is a schematic diagram of a cross-sectional structure of a structural member in the electronic device shown in FIG. 2 in a first implementation;
FIG. 4 is an enlarged schematic structural diagram of a region A in the structural member shown in FIG. 3;
FIG. 5 is a schematic diagram of a cross-sectional structure of a structural member in the electronic device shown in FIG. 2 in a second implementation;
FIG. 6 is an enlarged schematic structural diagram of a region B in the structural member shown in FIG. 5;
FIG. 7 is a schematic diagram of a cross-sectional structure of a structural member in the electronic device shown in FIG. 2 in a third implementation;
FIG. 8 is a schematic diagram of a cross-sectional structure of a structural member in the electronic device shown in FIG. 2 in a fourth implementation; and
FIG. 9 is a process flow diagram of a method for manufacturing a structural member according to an embodiment of this application.

### DESCRIPTION OF EMBODIMENTS

Technical solutions in embodiments of this application are clearly and completely described below with reference to the accompanying drawings in embodiments of this application.

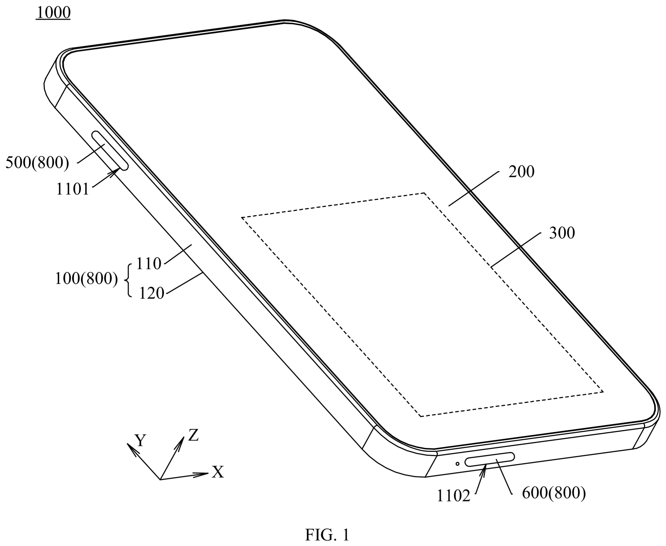

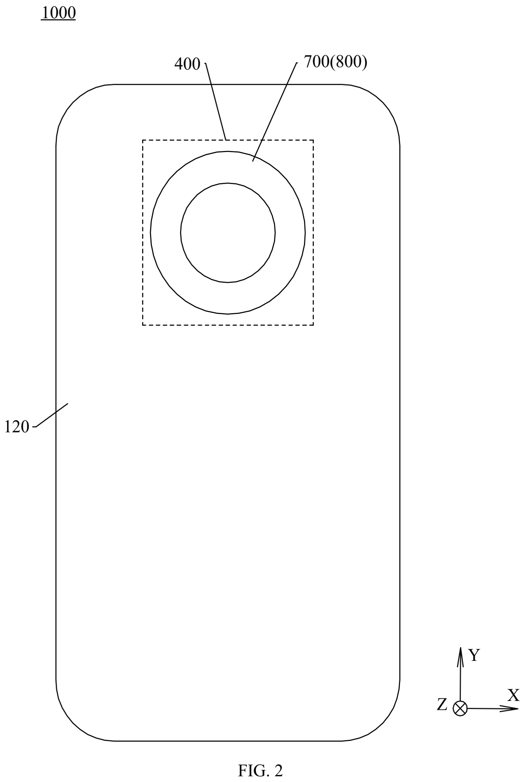

Refer to FIG. 1 and FIG. 2. FIG. 1 is a schematic structural diagram of an electronic device 1000 according to an embodiment of this application, and FIG. 2 is a schematic diagram of a back structure of the electronic device 1000 shown in FIG. 1.

The electronic device 1000 may be an electronic product such as a mobile phone, a tablet computer, a notebook computer, in-vehicle infotainment, a smart watch, a smart bracelet, or a POS terminal (point of sales terminal, point of sale terminal). Next, in this embodiment of this application, an example in which the electronic device 1000 is a mobile phone is used for description. For ease of description, a width direction of the electronic device 1000 is defined as an X-axis direction, a length direction of the electronic device 1000 is defined as a Y-axis direction, a thickness direction of the electronic device 1000 is defined as a Z-axis direction. The X-axis direction, the Y-axis direction, and the Z-axis direction are perpendicular to each other.

The electronic device 1000 includes a housing 100, a display module 200, a circuit board 300, a processor (not shown in the figure), a camera module 400, a button 500, a card holder 600, and a decoration member 700. The display module 200, the circuit board 300, the processor, the camera module 400, the button 500, the card holder 600, and the decoration member 700 are all mounted to the housing 100.

The housing 100 includes a frame 110 and a back cover 120. The back cover 120 is mounted to the frame 110. The frame 110 may be a middle frame of the electronic device 1000, and the back cover 120 may be a battery cover of the electronic device 1000. In some other embodiments, the frame 110 may also be another structural member in the electronic device 1000 that plays a supporting role.

The frame 110 is provided with a button hole 1101 and a card holder hole 1102. Openings of the button hole 1101 and the card holder hole 1102 are both located on a peripheral surface of the frame 110 (not marked in the figure). The button hole 1101 and the card holder hole 1102 are both recessed from the peripheral surface of the frame 110 toward an inner side of the frame 110, and extend through the frame 110 to bring the inner side and an outer side of the frame 110 into communication with each other. The button hole 1101 is located on a left side of the frame 110, and the card holder hole 1102 is located on a bottom side of the frame 110. In some other embodiments, the button hole 1101 may also be located on a right side, a top side, or the bottom side of the frame 110, and/or the card holder hole 1102 may also be located on the top side, the left side, or the right side of the frame 110.

It should be noted that the directional terms such as "top", "bottom", "up", "down", "left", and "right" involved in this application are described with reference to the directions shown in FIG. 1. A direction facing a positive direction of the Y axis is used as "top", a direction facing a negative direction of the Y axis is used as "bottom", a direction facing a positive direction of the Z axis is used as "up", a direction facing a negative direction of the Z axis is used as "down", a direction facing a positive direction of the X axis is used as "right", and a direction facing a negative direction of the X axis is used as "left". This does not indicate or imply that a referred apparatus or element needs to have a specific orientation and be constructed and operated in a specific orientation, and therefore should not be construed as a limitation on this application.

The back cover 120 is mounted to one side of the frame 110. For example, the back cover 120 may be detachably mounted to the frame 110 to facilitate maintenance and replacement of an internal device or module of the electronic device 1000. The back cover 120 is provided with an avoidance hole (not shown in the figure). The avoidance hole is located on a top side of the back cover 120. An opening of the avoidance hole is located on an upper surface of the back cover 120 (not marked in the figure). The avoidance hole is recessed from the upper surface of the back cover 120 toward a lower surface (not marked in the figure) (in the negative direction of the Z-axis shown in the figure), and extends through the lower surface of the back cover 120. In other words, the avoidance hole extends through the back cover 120 along a thickness direction of the back cover 120.

The display module 200 is mounted to a side of the housing 100. Specifically, the display module 200 is mounted to the other side of the frame 110. In other words, the display module 200 is mounted to a side of the frame 110 facing away from the back cover 120. In other words, the display module 200 and the back cover 120 are respectively mounted to two opposite sides of the frame 110. When a user uses the electronic device 1000, the display module 200 is placed toward the user, and the back cover 120 is placed away from the user. The display module 200 may be a display screen such as an LCD (liquid crystal display, liquid crystal display) or an OLED (organic light-emitting diode, organic light-emitting diode) display screen, and is configured to display information such as an image or text.

The circuit board 300, the processor, and the camera module 400 are all mounted to an inner side of the housing 100. The processor may be mounted to the circuit board 300 and electrically connected to the circuit board 300. The circuit board 300 may be a mainboard (mainboard) of the electronic device 1000, and the processor may be a CPU (central processing unit, central processing unit) of the electronic device 1000. The camera module 400 is mounted to a top side of the housing 100 and electrically connected to the circuit board 300, so as to establish an electrical connection with the processor. The camera module 400 may serve as a rear camera module of the electronic device 1000, and a camera surface (not shown in the figure) of the camera module 400 may be exposed relative to the avoidance hole of the back cover 120. The camera module 400 may receive an information collection signal sent by the processor through the circuit board 300, and collect light outside the electronic device 1000 through the camera surface, to form corresponding image data.

The button 500 and the card holder 600 are both mounted to the frame 110. Specifically, the button 500 is mounted to the button hole 1101, and the card holder 600 is mounted to the card holder hole 1102. The button 500 may be a function button such as a power button, a volume button, or a screen lock button of the electronic device 1000. The card holder 600 may carry a SIM card (Subscriber Identity Module, subscriber identity module) or a TF card (Trans-flash Card), and the like.

In this embodiment, the decoration member 700 may be a camera decoration member. The decoration member 700 is mounted to the back cover 120 and covers the camera module 400. Not only the camera module 400 may be protected, but also aesthetic quality of the electronic device 1000 may be enhanced. For example, the decoration member 700 is in a shape of a circular ring. In some other embodiments, the decoration member 700 may also be another decoration member of the electronic device 1000. For example, the decoration member 700 may be a receiver decoration member. The decoration member 700 is mounted to a receiver hole of the frame 110.

It may be understood that the housing 100, the button 500, the card holder 600, and the decoration member 700 are all structural members 800 of the electronic device 1000, and all have impact on the aesthetic quality of the electronic device 1000. Therefore, during the manufacturing of the structural member 800, a coating process is often adopted to form a metal coating layer to achieve a metal-like effect, to enhance the aesthetic quality of the electronic device 1000. Next, the decoration member 700 is used as an example. The structural member 800 of the electronic device 1000 is described in detail.

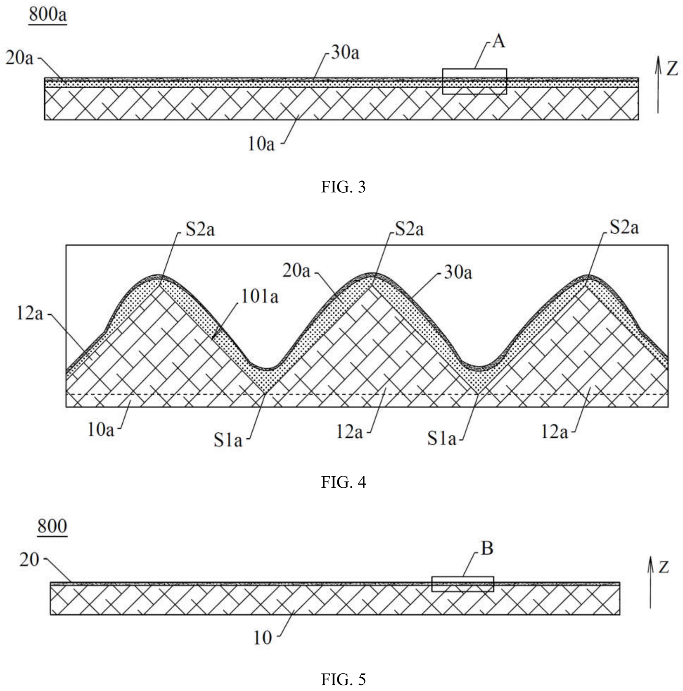

Refer to FIG. 3 and FIG. 4. FIG. 3 is a schematic diagram of a cross-sectional structure of a structural member 800a in the electronic device 1000 shown in FIG. 2 in a first implementation, and FIG. 4 is an enlarged schematic structural diagram of a region A in the structural member 800a shown in FIG. 3.

In this implementation, the structural member 800a includes a substrate 10a, a priming coat 20a, and a metal coating layer 30a. The substrate 10a includes an outer surface 101a, the priming coat 20a is arranged on the outer surface 101a, and the metal coating layer 30a is arranged on a surface of the priming coat 20a facing away from the outer surface 101a. Specifically, the outer surface 101a is provided with a textured pattern. The textured pattern includes a plurality of textured pattern units 12a, and the priming coat 20a covers the plurality of textured pattern units 12a. For example, each textured pattern unit 12a is in a shape of a rectangular pyramid, and a cross section of each textured pattern unit 12a is in a shape of a triangle. It should be noted that the textured pattern belongs to a part of the substrate 10a, and the textured pattern is formed by performing shape processing on the outer surface 101a of the substrate 10a.

The substrate 10a is made of conventional engineering plastics. For example, the conventional engineering plastics may be one or more of polycarbonate (PC, Polycarbonate), polyacrylic acid (PA, Polyacrylic acid), acrylonitrile butadiene styrene (ABS, Acrylonitrile Butadiene Styrene), or a complex of polycarbonate and acrylonitrile butadiene styrene.

It should be noted that in the foregoing implementations, based on the characteristics of conventional engineering plastics, the conventional engineering plastics have no polar group and have a relatively high coefficient of thermal expansion. The conventional engineering plastics have poor adhesion to metal atoms of the metal coating layer 30a. When the metal coating layer 30a is formed on the outer surface 101a of the substrate 10a, the adhesion of the metal coating layer 30a is relatively poor, and the metal coating layer 30a affects use reliability of the structural member 800a. Therefore, it is often necessary to first perform a primer treatment on the outer surface 101a of the substrate 10a to form the priming coat 20a, and then form the metal coating layer 30a on the surface of the priming coat 20a facing away from the substrate 10a through a non-conductive vacuum metallization (NCVM, Non conductive vacuum metallization) process. The manufacturing process of the structural member 800a is complex, and the production efficiency is low. Moreover, during the spraying to form the priming coat 20a, a large amount of solvent needs to be used, causing great pollution. In addition, because the priming coat 20a is often formed by curing a liquid resin, and the liquid resin has good fluidity and may accumulate at a sharp corner position Sla between two adjacent textured pattern units 12a, a phenomenon of resin accumulation may occur, and the sharp corner position S2a between the textured pattern units 12a may become blunt. After the liquid resin is subsequently cured to form the priming coat 20a, the priming coat 20a reduces the metal texture of the structural member 800a.

It should be understood that when the structural member 800a is used in the electronic device, the outer surface 101a of the substrate 10a is a surface of the substrate 10a facing an outer side of the electronic device 1000, that is, the outer surface 101a of the substrate 10a is a surface of the substrate 10a facing away from an inner side of the electronic device 1000. The description of "outer surface" in this application document may be understood in the same way.

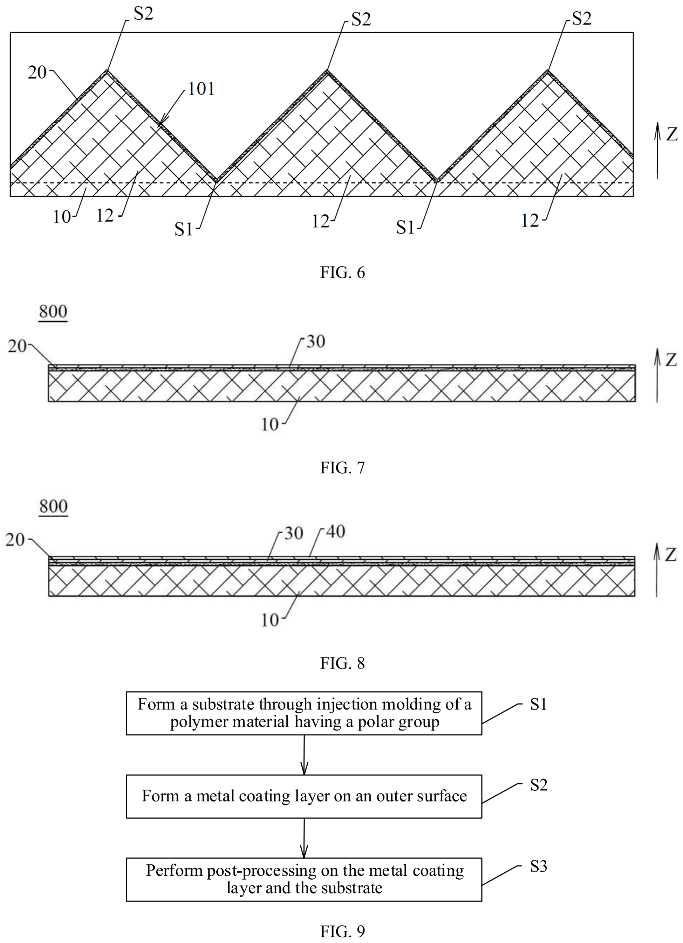

Refer to FIG. 5 and FIG. 6. FIG. 5 is a schematic diagram of a cross-sectional structure of a structural member 800 in the electronic device 1000 shown in FIG. 2 in a second implementation, and FIG. 6 is an enlarged schematic structural diagram of a region B in the structural member 800 shown in FIG. 5.

The structural member 800 includes a substrate 10 and a metal coating layer 20. The substrate 10 includes an outer surface 101, and the metal coating layer 20 is arranged on the outer surface 101. Specifically, the outer surface 101 is provided with a textured pattern. The textured pattern includes a plurality of textured pattern units 12, and the metal coating layer 20 covers the textured pattern. In this embodiment, the substrate 10 is made of a polymer material having a polar group. The polar group has high temperature resistance. The polar group may be an imide group, a sulfone group, a diphenyl sulfone group, a phthalamide group. It should be noted that in some other implementations, the substrate 10 may not include the textured pattern unit 12. This is not specifically limited in this application.

The polymer material is special engineering plastics. The special engineering plastics may be at least one of polyetherimide (PEI, Polyetherimide), polysulfone (PSU, Polysulfone) plastics, polyethersulfone (Polyethersulfone, PES), polyphenylene sulfone resins (PPSU, Polyphenylene sulfone resins), and polyphthalamide (PPA, Polyphthalamide).

It should be noted that the substrate 10 is made of non-crystalline special engineering plastics, and the polar groups of the special engineering plastics may form a strong bonding force with the metal coating layer 20. The bonding force between the substrate 10 and the metal coating layer 20 is relatively strong. Therefore, the metal coating layer 20 may be directly formed on the outer surface 101 of the substrate 10 without the need to design a priming coat between the metal coating layer 20 and the outer surface 101. This not only simplifies the manufacturing process of the structural member 800 and improves the production efficiency of the structural member 800, but also reduces the pollution caused during the manufacturing of the structural member 800 since the priming coat does not need to be formed by spraying and no large amount of solvent is required during the manufacturing of the structural member 800. In addition, since the metal coating layer 20 may be directly formed on the outer surface 101, no priming coat is accumulated in a sharp corner position S1 between two adjacent textured pattern units 12. A sharp corner position S2 of the textured pattern unit 12 is not to become blunt. This helps enhance metal texture of the structural member 800.

When the polymer material weighing 2.16 kg is at a temperature of 350 degrees Celsius, a flow rate of the polymer material is greater than or equal to 22 g/min. A test for fluidity of the polymer material used for the substrate 10 meets the international standard ISO 1133. In other words, the polymer material used for the substrate 10 has a high melt index and high fluidity. During formation of the substrate 10 through injection molding, this not only helps obtain a high-quality outer surface, but also helps achieve high-precision molding of the substrate 10, and may reduce other appearance defects such as weld marks on the substrate 10. It may be understood that the fluidity of the polymer material may be adjusted by controlling a molecular weight and adding a plasticizer.

The heat distortion temperature of the polymer material used for the substrate 10 is greater than or equal to 175 degrees Celsius. A test for the heat distortion temperature of the polymer material used for the substrate 10 meets the international standard ISO 75-1/-2. In other words, the polymer material used for the substrate 10 has high heat resistance. When the substrate 10 is formed by injection molding through the polymer material, high-temperature and high-speed injection molding may be performed to obtain a substrate 10 with high surface quality. Moreover, the good heat resistance helps the substrate 10 form the metal coating layer 20 subsequently through high-temperature sputtering coating. Furthermore, during the formation of the metal coating layer 20, due to the high heat resistance of the polymer material, thermal deformation does not occur in the substrate 10. Not only the metal coating layer 20 may be well formed on the outer surface 101, to improve the bonding force between the substrate 10 and the metal coating layer 20 and ensure quality of the metal coating layer 20, but also productivity of the metal coating layer 20 is improved. A mirror effect grade of the outer surface of the substrate 10 is less than or equal to A3, and roughness Ra is less than or equal to 0.06 µm. High surface quality of the substrate 10 helps improve the bonding force between the substrate 10 and the metal coating layer 20.

In addition, surface hardness of the outer surface of the substrate 10 is greater than or equal to F, that is, the outer surface of the substrate 10 has relatively high surface hardness. This not only helps reduce scratches on the substrate 10, but also may prevent the metal coating layer 20 from cracking. It should be noted that notched impact strength of the substrate 10 is greater than or equal to 4 kJ/m2. A test for the notched impact strength of the substrate 10 meets the international standard ISO 180. The substrate 10 has relatively high impact strength. This helps improve toughness and impact strength of the structural member 800, and enhances the use reliability of the structural member 800. A flexural modulus of the substrate 10 is greater than or equal to 2500 MPa. A test for the flexural modulus of the substrate 10 meets the international standard ISO 178. The substrate 10 has a high modulus. This not only helps improve strength and rigidity of the structural member 800, but also may directly form the metal coating layer 20 on the outer surface 101 of the substrate 10 without the need to design a priming coat.

A coefficient of thermal expansion of the polymer material is less than or equal to 60*10⁻⁶/K. A test for the coefficient of thermal expansion of the polymer material meets the international standard ISO 11359. The polymer material has a relatively low coefficient of thermal expansion. It should be noted that during the formation of the metal coating layer 20, a temperature of an environment where the metal coating layer 20 is formed where the substrate 10 is located experiences a process from a low temperature (such as a room temperature) to a high temperature (such as a temperature at which metal coating may be performed) and then to a low temperature (such as a temperature after cooling). Due to the low coefficient of thermal expansion of the polymer material, the substrate 10 does not expand or contract significantly. This helps improve the quality of the metal coating layer 20 and ensures use reliability of the structural member 800. Moreover, since the coefficient of thermal expansion of the metal coating layer 20 is between 5*10⁻⁶/K and 25*10⁻⁶/K, the relatively low coefficient of thermal expansion of the polymer material may reduce a difference in the coefficients of thermal expansion between the substrate 10 and the metal coating layer 20. When the structural member 800 is used in a high-temperature or low-temperature environment, a deformation difference between the substrate 10 and the metal coating layer 20 is not too great. This helps enhance structural stability between the substrate 10 and the metal coating layer 20, and may further prevent the metal coating layer 20 from cracking.

In this embodiment, a material of the metal coating layer 20 includes at least one of titanium, chromium, tungsten, vanadium, niobium, zirconium, hafnium, titanium carbide, and tungsten carbide. A thickness of the metal coating layer is between 0.2 µm and 8 µm, a pencil hardness test is ≥ 2H, and the adhesion ≥ 4B. The metal coating layer 20 not only has a high-quality metal effect, such as a stainless steel-like texture, but also may obtain different colors by selecting different metal materials. This helps realize personalized design of the structural member 800. The adhesion of the metal coating layer 20 is measured through a cross-cut test.

Refer to FIG. 7. FIG. 7 is a schematic diagram of a cross-sectional structure of a structural member 800 in the electronic device 1000 shown in FIG. 2 in a third implementation.

A difference between the structural member 800 shown in this implementation and the structural member 800 shown in the second implementation above is that the structural member 800 further includes a topcoat layer 30. The topcoat layer 30 is arranged on a surface of the metal coating layer 20 facing away from the substrate 10. The topcoat layer 30 not only may protect the metal coating layer 20 and the substrate 10, but also may play a decorative role, to improve aesthetic quality of the structural member 800.

Refer to FIG. 8. FIG. 8 is a schematic diagram of a cross-sectional structure of a structural member 800 in the electronic device 1000 shown in FIG. 2 in a fourth implementation.

A difference between the structural member 800 shown in this implementation and the structural member 800 shown in the third implementation above is that the structural member 800 may further include a color paint layer 40. The color paint layer 40 is arranged on a surface of the metal coating layer 20 facing away from the substrate 10. A topcoat layer 30 is arranged on a surface of the color paint layer facing away from the metal coating layer 20.

In the electronic device 1000 shown in this embodiment, the substrate 10 of the structural member 800 is made of a polymer material having a polar group. The polymer material has high heat resistance and a low coefficient of thermal expansion, so that the metal coating layer 20 may be directly formed on the outer surface 101 of the substrate 10 to achieve an appearance comparable to that of metal, such as a stainless steel-like appearance, without the need to design a priming coat. This not only simplifies a manufacturing process of the structural member 800 and improves production efficiency of the structural member 800, but also may reduce production costs of the structural member 800 and a weight of the structural member 800.

Refer to FIG. 9. FIG. 9 is a process flow diagram of a method for manufacturing a structural member according to an embodiment of this application.

This application provides a method for manufacturing a structural member, which is used to manufacture the foregoing structural member 800. The method for manufacturing a structural member includes step S1 and step S2.

Step S1: Form a substrate 10 through injection molding of a polymer material having a polar group. A heat distortion temperature of the polymer material is greater than or equal to 175°C, a coefficient of thermal expansion of the polymer material is less than or equal to 60*10⁻⁶/K, and the substrate 10 includes an outer surface 101. In this embodiment, the outer surface 101 is provided with a textured pattern. The textured pattern includes a plurality of textured pattern units 12. For example, each textured pattern unit 12 is in a shape of a rectangular pyramid, and a cross section of each textured pattern unit 12 is in a shape of a triangle. The polymer material may be plastic particles. For example, the polymer material is special engineering plastics. The special engineering plastics may be at least one of polyetherimide, polysulfone plastics, polyethersulfone, polyphenylene sulfone resin, and polyphthalamide.

Specifically, after the polymer material is melted and plasticized and then injected into a plastic structural member mold, and injection molding is performed at a high temperature and a high speed, to obtain the substrate 10 with high surface quality. The substrate 10 does not have a weld line. A thickness of the substrate 10 is greater than or equal to 0.35 mm, a mirror effect grade of the outer surface of the substrate 10 is less than or equal to A3, and roughness Ra is less than or equal to 0.06 µm. In some other embodiments, the thickness of the substrate 10 may also be greater than or equal to 0.25 mm.

It should be noted that during formation of the substrate 10 through injection molding, a hot-to-cold runner three-plate mold is preferably selected. The mold may be an electroformed insert, and a surface of the mold undergoes high-gloss polishing. The mirror effect grade of the surface of the mold is less than or equal to A3, and the roughness Ra is less than or equal to 0.06 µm. In addition, the polymer material is injected into the injection mold through single-point gate feeding to avoid weld lines or deformation in the substrate 10. This helps improve surface quality of the substrate 10. A drying condition for the plastic particles is preferably 140°C/6H. A temperature of the injection mold (that is, a mold temperature) ranges from 135°C to 170°C. A temperature of the polymer material (that is, a material temperature) ranges from 330°C to 400°C. An injection pressure of the polymer material injected into the injection mold ranges from 700 bar to 1500 bar. An injection speed (that is, an injection rate) is greater than or equal to 20 mm/s to improve the surface quality of the substrate 10.

When the polymer material weighing 2.16 kg is at a temperature of 350 degrees Celsius, fluidity of the polymer material is greater than or equal to 22 g/min, to facilitate formation of the substrate 10 by injection molding through single-point gate feeding. A test for fluidity of the polymer material used for the substrate 10 meets the international standard ISO 1133. In other words, the polymer material used for the substrate 10 has a high melt index and high fluidity. This not only helps achieve high-precision molding of the substrate 10, but also helps obtain a high-quality outer surface, and reduces other appearance defects such as weld lines on the outer surface of the substrate 10.

Step S2: Form a metal coating layer 20 on the outer surface 101. A material of the metal coating layer 20 includes at least one of titanium, chromium, tungsten, vanadium, niobium, zirconium, hafnium, titanium carbide, and tungsten carbide. For example, a thickness of the metal coating layer 20 is in a range of 0.2 µm to 8 µm. A pencil hardness test of the metal coating layer 20 is ≥ 2H, and adhesion of the metal coating layer 20 is ≥ 4B. The metal coating layer 20 not only has a high-quality metal effect, but also may obtain different colors by selecting different metal materials. This helps improve the aesthetic quality of the structural member 800. The adhesion of the metal coating layer 20 is measured through a cross-cut test.

Specifically, the substrate 10 is placed into a vacuum coating machine for high-temperature sputtering coating to form the metal coating layer 20 on the outer surface 101. For example, the metal coating layer 20 is formed through physical vapor deposition (PVD, Physical Vapor Deposition). It should be noted that since the polymer materials used for the substrate 10 are all non-crystalline special engineering plastics, and the polar groups of the non-crystalline special engineering plastics facilitate formation of a strong bonding force between the substrate 10 and the metal coating layer 20. Therefore, coating may be directly performed on the outer surface 101 through the process of physical vapor deposition. Moreover, since the heat distortion temperature of the polymer material used for the substrate 10 is greater than or equal to 175°C, the polymer material used for the substrate 10 has a characteristic of high heat resistance. This helps the substrate 10 undergo the high-temperature sputtering coating. In addition, since the coefficient of thermal expansion of the polymer material used for the substrate 10 is less than or equal to 60*10⁻⁶/K, the polymer material has a relatively low coefficient of thermal expansion. The relatively low coefficient of thermal expansion of the substrate 10 not only may reduce a difference in coefficients of thermal expansion between the substrate 10 and the metal coating layer 20, helps enhance structural stability between the substrate 10 and the metal coating layer 20, but also may prevent the metal coating layer 20 from cracking.

It should be noted that the metal coating layer 20 is formed through a high temperature sputtering coating process. The metal coating layer 20 has high purity, good density, and a strong bonding force with the substrate 10. This helps improve the use reliability of the structural member 800. In addition, compared with the conventional vacuum non-conductive coating process of forming the metal coating layer, the high-temperature sputtering coating process is simpler and pollution-free. Furthermore, the non-conductive vacuum coating process is often used for surface decoration of glass-fiber-filled polycarbonate (PC, Polycarbonate) resin components. Through use of the physical vapor deposition process, three spraying steps may be omitted. In particular, components using the non-conductive vacuum coating are also prone to oil accumulation and fat edges. This is not conducive to achieving high-quality metallization effects.

In some other embodiments, the coating may also be directly performed on the outer surface 101 of the substrate 10 through physical vapor deposition, or the coating may be performed on the outer surface 101 of the substrate 10 through processes such as vacuum non-conductive plating, ordinary spraying, or water plating. This is not specifically limited in this application.

It should be noted that the method for manufacturing a structural member may further include step S3 of post-processing the metal coating layer 20 and the substrate 10. Specifically, the substrate 10 formed with the metal coating layer 20 may be post-processed through a computer numerical control (CNC, Computer numerical control) machine tool or sprayed with a transparent topcoat based on actual requirements of a product.

In the method for manufacturing a structural member shown in embodiments of this application, the metal coating layer 20 is directly formed on the outer surface 101 of the substrate 10. Through the method, the structural member 800 with a high-precision metal-like appearance effect may be easily manufactured. The structural member 800 has high gloss, good flatness, excellent reliability, strong product performance, low costs, and a light weight. The metal coating layer 20 and the substrate 10 are firmly bonded, have excellent wear resistance, and are not easy to crack or fall off. The structural member 800 manufactured through the method has both an exquisite appearance effect and a light weight, and has strong monetization ability. Moreover, the structural member 800 manufactured through the method has relatively high strength, good toughness, good dimensional stability, and excellent chemical resistance.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Embodiments of this application and features in the embodiments may be combined with each other in a case that no conflict occurs. Therefore, the protection scope of this application shall be subject to the protection scope of the claims.

## Claims

1. A structural member, comprising a substrate and a metal coating layer, wherein the substrate comprises an outer surface, the metal coating layer is arranged on the outer surface, the substrate is made of a polymer material having a polar group, a heat distortion temperature of the polymer material is greater than or equal to 175°C, and a coefficient of thermal expansion of the polymer material is less than or equal to 60*10⁻⁶/K.

2. The structural member according to claim 1, wherein a flow rate of the polymer material weighing 2.16 kg at 350°C is greater than or equal to 22 g/10 min.

3. The structural member according to claim 1 or 2, wherein a mirror effect grade of the outer surface of the substrate is less than or equal to A3, and roughness of the outer surface of the substrate is less than or equal to 0.06 µm.

4. The structural member according to any one of claims 1 to 3, wherein the outer surface is provided with a textured pattern, and the metal coating layer covers the textured pattern.

5. The structural member according to any one of claims 1 to 4, wherein adhesion of the metal coating layer is greater than or equal to 4B.

6. The structural member according to any one of claims 1 to 5, wherein the polar group is an imide group, a sulfone group, a diphenyl sulfone group, or a phthalamide group.

7. The structural member according to any one of claims 1 to 6, wherein the polymer material comprises at least one of polyetherimide, polysulfone plastics, polyethersulfone, polyphenylene sulfone resin, and polyphthalamide.

8. The structural member according to any one of claims 1 to 7, wherein a material of the metal coating layer comprises at least one of titanium, chromium, tungsten, vanadium, niobium, zirconium, hafnium, titanium carbide, and tungsten carbide.

9. The structural member according to any one of claims 1 to 8, wherein the substrate does not contain a weld line.

10. An electronic device, comprising a housing and the structural member according to any one of claims 1 to 9, wherein the structural member is mounted to the housing.

11. The electronic device according to claim 10, wherein the structural member is a button, a card holder, or a decoration member.

12. A method for manufacturing a structural member, comprising:
forming a substrate through injection molding of a polymer material having a polar group, wherein a heat distortion temperature of the polymer material is greater than or equal to 175°C, a coefficient of thermal expansion of the polymer material is less than or equal to 60*10⁻⁶/K, and the substrate comprises an outer surface; and
forming a metal coating on the outer surface.

13. The method for manufacturing a structural member according to claim 12, wherein in the step of forming the metal coating on the outer surface, the metal coating is formed through a process of physical vapor deposition.

14. The method for manufacturing a structural member according to claim 12 or 13, wherein in the step of forming the substrate through injection molding of the polymer material having the polar group, a mold temperature of an injection mold is between 135°C and 170°C, a temperature of the polymer material is between 330°C and 400°C, an injection pressure of the polymer material injected into the injection mold is between 700 bar and 1500 bar, and an injection speed is greater than or equal to 20 mm/s.

15. The method for manufacturing a structural member according to claim 14, wherein the polymer material is injected into the injection mold through single-point gate feeding.
